# EUROPEAN PATENT SPECIFICATION

(11) **EP 3 451 396 B1**
(45) Date of publication and mention of the grant of the patent: **17.07.2024**
(21) Application number: 18192224.6
(22) Date of filing: 03.09.2018
(51) Int. Cl.: H01L 33/62, H01L 33/64, H01L 33/48, H01L 33/60

(54) **SEMICONDUCTOR DEVICE PACKAGE**
HALBLEITERBAUELEMENTGEHÄUSE
CONDITIONNEMENT DE DISPOSITIF À SEMICONDUCTEUR

(30) Priority: 05.09.2017 KR 20170113439; 28.08.2018 KR 20180101576
(43) Date of publication of application: 06.03.2019
(73) Proprietor: Suzhou Lekin Semiconductor Co., Ltd., Taicang City, Suzhou (CN)
(72) Inventor: LEE, Koh Eun, 04637 Seoul (KR); KANG, Hui Seong, 04637 Seoul (KR); KIM, Ga Yeon, 04637 Seoul (KR); LEE, Yeong June, 04637 Seoul (KR); JIN, Min Ji, 04637 Seoul (KR); YOON, Jae Joon, 04637 Seoul (KR)
(74) Representative: Lewis Silkin LLP

(56) References cited:
- DE-A1- 102014 103 034
- JP-A- 2003 168 828
- US-A1- 2011 140 143
- US-A1- 2012 275 181
- US-A1- 2015 049 447
- US-A1- 2015 243 864
- US-A1- 2015 280 072

## Description

### BACKGROUND

### 1. Field of the Disclosure

The present disclosure relates to a semiconductor device package.

### 2. Discussion of Related Art

Semiconductor devices including a compound, such as gallium nitride (GaN), aluminum gallium nitride (AlGaN), and the like, have many advantages, such as wide and easily adjustable bandgap energy, and may be variously used for a light-emitting device, a light-receiving element, various diodes, and the like.

In particular, light-emitting devices, such as light-emitting diodes (LEDs) and laser diodes (LDs) using Group III-V or Group II-VI compound semiconductor materials of semiconductors, may realize various colors, such as red, green, blue, and ultraviolet (UV) light, with the development of thin-film growth techniques and device materials. The light-emitting devices may realize white light rays having high efficiency by using phosphor materials or combining colors. In addition, the light-emitting devices have merits such as low power consumption, a semi-permanent life span, a fast response speed, safety, and environmental friendliness as compared with conventional light sources, such as fluorescent lamps and incandescent lamps.

Furthermore, when light-receiving elements, such as photodetectors or solar cells, are manufactured using Group III-V or Group II-VI compound semiconductor materials of semiconductors, due to the development of device materials, the light-receiving elements may absorb light having various wavelength ranges and generate photocurrent. Thus, the light-receiving elements may use light in a wide variety of wavelength ranges from gamma rays to a radio wavelength range. Further, since the light-receiving elements have advantages of a fast response speed, safety, environmental friendliness, and easy control of device materials, the light-receiving elements may be easily used for power control circuits, microwave circuits, or communication modules.

Accordingly, applications of semiconductor devices may be extended to transmission modules of optical communication units, LED backlights capable of replacing cold cathode fluorescent lamps (CCFLs) included in backlights of liquid-crystal display (LCD) devices, white LED lighting devices capable of replacing fluorescent lamps or incandescent lamps, car headlights, traffic lights, and sensors configured to detect gas or fire. In addition, the applications of the semiconductor devices may be extended to high-frequency applied circuits, other power control devices, and communication modules.

In particular, light-emitting devices configured to emit light in a UV wavelength range may perform a curing operation or a sterilization operation and be used for curing, medical, and sterilization purposes.

Recently, a large amount of research has been conducted into UV light-emitting device packages. However, UV light-emitting devices still have relatively low light extraction efficiency and cannot effectively emit internal heat to the outside.

US2115/280072A1 discloses an LED package including an insulting film provided between a first interconnect portion and a second interconnect portion, and at an outer periphery of a side face layer of a semiconductor layer. US 2012/275181 A1 discloses a light emitting device package including a body, first and second reflection cups spaced apart from each other in a top surface of the body, a first connection pad disposed in the top surface of the body, spaced apart from the first and second reflection cups, a first light emitting diode mounted in the first reflection cup, a second light emitting diode mounted in the second reflection cup, and a partition wall disposed between the first reflection cup and the second reflection cup, wherein the partition wall is extended from the top surface of the body upwardly. DE 10 2014 103034 A1 discloses an optoelectronic component. US 2015/243864 A1 discloses an optical device. JP 2003 168828A discloses a surface-mount type light emitting diode.

### SUMMARY OF THE DISCLOSURE

The present disclosure is directed to providing a semiconductor device package having excellent heat radiation characteristics. The present invention is defined by the appended claims. In the present description and drawings, any examples and technical descriptions of apparatuses, products and/or methods which are not covered by the claims should be taken as background art or examples useful for understanding the invention.

Embodiments provide a semiconductor device package having high light extraction efficiency.

Embodiments provide a semiconductor device package which may inhibit occurrence of burrs during a package cutting process.

Aspects of the present disclosure should not be limited by the above descriptions and also include objects or effects that can be understood from the following solutions and embodiments described therein

According to an aspect of the present disclosure, there is provided a semiconductor device package including: a resin unit having a first through hole and a second through hole, a conductive body disposed on the resin unit and having a cavity that is concave in a first direction from a top surface of the conductive body toward a bottom surface thereof, and a light-emitting device disposed in the cavity. The conductive body includes a first protrusion and a second protrusion, which protrude in the first direction toward the bottom surface of the conductive body. The first protrusion is disposed inside the first through hole, and the second protrusion is disposed inside the second through hole. A top surface of the resin unit is in contact with a bottom surface of grooves disposed in the bottom surface of the conductive body

The first protrusion may be larger than the second protrusion.

A ratio of an area of the first protrusion to an area of the second protrusion may range from 1:0.2 to 1:0.6.

The first protrusion and the second protrusion may include aluminum.

The conductive body may include a first metal package body unit, a second metal package body unit, and a first insulating member disposed between the first metal package body unit and the second metal package body unit.

The first insulating member may be exposed at at least two outer side surfaces of a plurality of outer side surfaces of the conductive body.

The first insulating member may be connected to the resin unit.

A distance between the first protrusion and the second protrusion may be greater than a width of the first insulating member.

The resin unit and the first insulating member may include respectively different materials.

The first metal package body unit may include a first recess unit formed to have a thickness that is reduced in a direction toward the second metal package body unit, and a first groove and a third groove formed in corner regions where a side surface of the first metal package body unit meets a bottom surface of the first metal package body unit. The second metal package body unit may include a second recess unit formed to have a thickness that is reduced in a direction toward the first metal package body unit, and a second groove and a fourth groove formed in corner regions where a side surface of the second metal package body unit meets a bottom surface of the second metal package body unit. The resin unit may be disposed in the first and third grooves and the second and fourth grooves.

The first recess unit, the second recess unit, and the first insulating member may form the cavity.

A bottom surface of the resin unit may be coplanar with a bottom surface of the first protrusion and a bottom surface of the second protrusion.

The first metal package body unit may include a plurality of outer side surfaces and a first inner side surface that is in contact with the first insulating member. The second metal package body unit may include a plurality of outer side surfaces and a second inner side surface that is in contact with the first insulating member. The first and third grooves disposed in the bottom surface of the conductive body may include a first groove formed in a region where the bottom surface of the first metal package body unit meets the outer side surfaces of the first metal package body unit and a third groove formed in a region where the bottom surface of the first metal package body unit meets the first inner side surface of first metal package body unit. The second and fourth grooves disposed in the bottom surface of the conductive body may include a second groove formed in a region where the bottom surface of the second metal package body unit meets the outer side surfaces of the second metal package body unit and a fourth groove formed in a region where the bottom surface of the second metal package body unit meets the second inner side surface of the second metal package body unit. The third groove and the fourth groove may be connected to each other.

The resin unit may include a second insulating member disposed in the first groove and the second groove and a third insulating member disposed in the third groove and the fourth groove. A width of the third insulating member may be greater than a width of the first insulating member.

A thickness of the second insulating member may be different from a thickness of the third insulating member.

A thickness of the second insulating member may be greater than a thickness of the third insulating member.

A width of the second insulating member may be smaller than the width of the third insulating member.

The second insulating member may include the same material as the third insulating member, and the third insulating member may include a different material from the first insulating member.

The semiconductor device package may further include a light-transmissive member disposed on a step unit formed on an inner sidewall of the cavity.

A ratio of a width of the first groove to a width of the bottom surface of the first metal package body unit may range from 1:3 to 1:5.

According to another aspect of the present disclosure, there is provided a semiconductor device package including: a first metal package body unit; a second metal package body unit spaced apart from the first metal package body unit by a first insulating member; a light-emitting device electrically connected to the first metal package body unit and the second metal package body unit; and a light-transmissive member disposed on the first metal package body unit and the second metal package body unit. An upper portion of the first metal package body unit includes a first recess unit formed by reducing a thickness of the first metal package body unit. A lower portion of the first metal package body unit includes a first groove and a third groove formed along a plurality of outer side surfaces. An upper portion of the second metal package body unit includes a second recess unit formed by reducing a thickness of the second metal package body unit. A lower portion of the second metal package body unit includes a second groove and a fourth groove formed along a plurality of outer side surfaces. The first recess unit, the second recess unit, and the first insulating member form a cavity. The light-emitting device is disposed in the cavity and the semiconductor device package further includes a second insulating member disposed in the first groove and the second groove.

### BRIEF DESCRIPTION OF THE DRAWINGS

The above and other objects, features and advantages of the present disclosure will become more apparent to those of ordinary skill in the art by describing in detail exemplary embodiments thereof with reference to the accompanying drawings, in which:
FIG. 1 is a perspective view of a semiconductor device package according to an exemplary embodiment of the present disclosure;
FIG. 2 is a plan view of a semiconductor device package according to an exemplary embodiment of the present disclosure;
FIG. 3 is a cross-sectional view of a semiconductor device package according to an exemplary embodiment of the present disclosure;
FIG. 4 is a bottom view of a semiconductor device package according to an exemplary embodiment of the present disclosure;
FIG. 5 is an exploded view of FIG. 3;
FIG. 6A is a conceptual diagram of a semiconductor device according to an exemplary embodiment of the present disclosure;
FIG. 6B illustrates a modified example of FIG. 6A;
FIG. 7 is a cross-sectional view of a semiconductor device package according to another exemplary embodiment of the present disclosure;
FIG. 8 is a cross-sectional view of a semiconductor device package according to still another exemplary embodiment of the present disclosure;
FIG. 9 illustrates a modified example of FIG. 1; and
FIGS. 10A to 10E are diagrams illustrating a process of manufacturing a semiconductor device package according to an exemplary embodiment of the present disclosure.

### DETAILED DESCRIPTION OF EXEMPLARY EMBODIMENTS

The embodiments may be modified in other forms, or several embodiments may be combined with one another. The scope of the present disclosure is not limited to each of the embodiments described below.

Even when content described in a specific embodiment is not described in other embodiments, the content may be understood as being related to other embodiments unless described otherwise or the content contradicts the specific embodiment in the other embodiments.

For example, when features of a component A are described in a specific embodiment and features of a component B are described in another embodiment, it should be understood that embodiments in which the component A is combined with the component B fall within the scope and spirit of the present disclosure even when they are not explicitly described.

In the description of the embodiments, it will be understood that when an element is referred to as being "on or under" another element, the two elements may be in direct contact with each other or at least one intervening element may be present between the two elements. Further, the term "on or under" can encompass both an orientation of above and below on the basis of one element.

Exemplary embodiments of the present disclosure that can be easily implemented by one skilled in the art will now be described more fully with reference to the accompanying drawings in which the exemplary embodiments of the disclosure are shown.

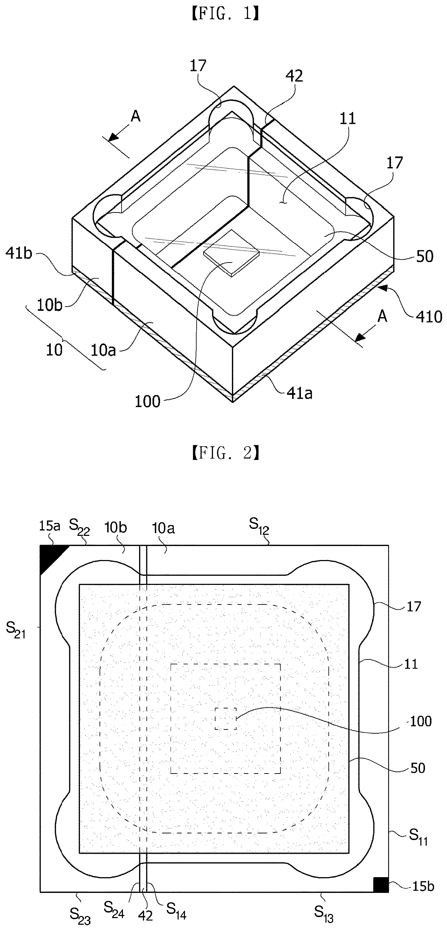

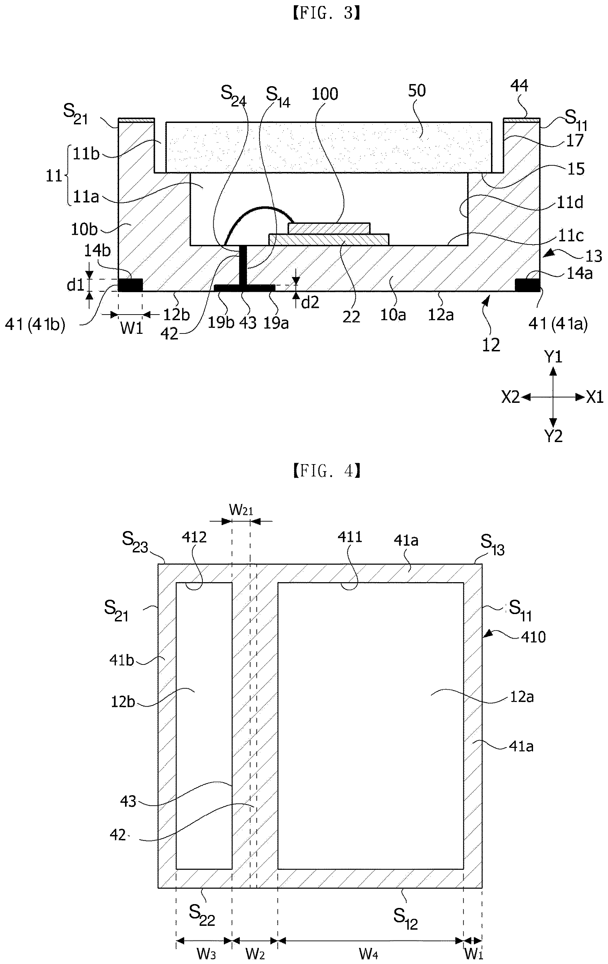

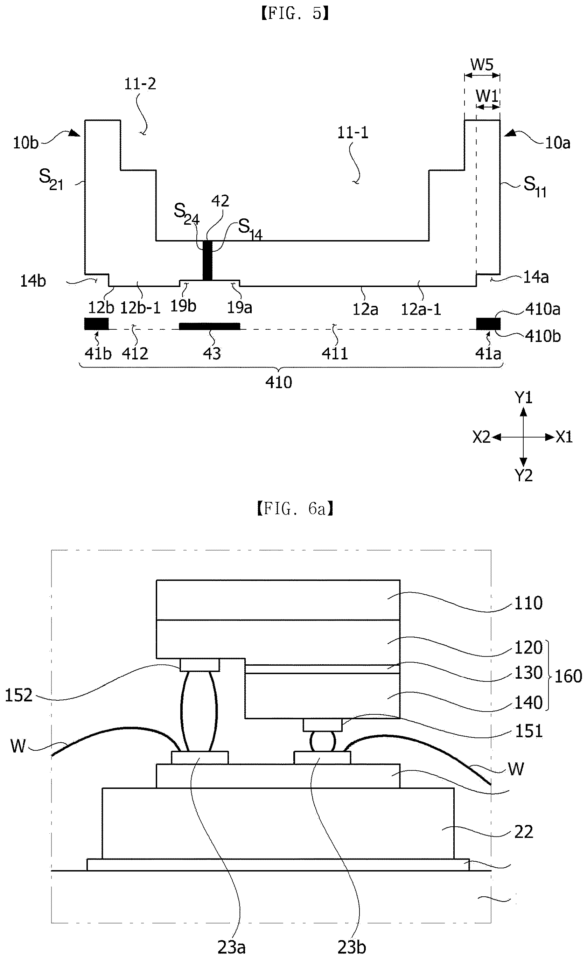

FIG. 1 is a perspective view of a semiconductor device package according to an exemplary embodiment of the present disclosure. FIG. 2 is a plan view of a semiconductor device package according to an exemplary embodiment of the present disclosure. FIG. 3 is a cross-sectional view of a semiconductor device package according to an exemplary embodiment of the present disclosure. FIG. 4 is a bottom view of a semiconductor device package according to an exemplary embodiment of the present disclosure. FIG. 5 is an exploded view of FIG. 3.

Referring to FIGS. 1 and 2, the semiconductor device package according to the exemplary embodiment may include a body 10 including a cavity 11, a semiconductor device 100 disposed inside the cavity 11, and a light-transmissive member 50 disposed on the cavity 11.

The body 10 may be manufactured by processing an aluminum substrate. Accordingly, both an inner surface and an outer surface of the body 10 according to the exemplary embodiment may have conductivity. The above-described structure of the body 10 may have various merits. When a non-conductive material, such as aluminum nitride (AIN) or aluminum oxide (Al₂O₃), is used for the body 10, since a reflectance of the body 10 in an ultraviolet (UV) wavelength band is only 20 to 40%, an additional reflective member should be disposed. Further, additional conductive members, such as lead frames, and a circuit pattern may be needed. Accordingly, manufacturing costs may increase, and processes may be complicated. In addition, a conductive member, such as gold (Au) may absorb UV light to reduce light extraction efficiency.

However, according to the exemplary embodiment, since the body 10 itself is formed of aluminum, a reflectance of the body 10 in the UV wavelength band may be high so that an additional reflective member may be omitted. Further, since the body 10 itself has conductivity, additional circuit patterns and lead frames may be omitted. In addition, since the body 10 is formed of aluminum, the body 10 may have a good thermal conductivity of 140 W/m^{·}K to 160 W/m'K.

Accordingly, heat radiation efficiency may be improved.

The body 10 may include a first metal package body unit 10a and a second metal package body unit 10b. A first insulating member 42 may be disposed between the first metal package body unit 10a and the second metal package body unit 10b. Since both the first metal package body unit 10a and the second metal package body unit 10b have conductivities, it may be necessary to dispose the first insulating member 42 to separate a polarity of the first metal package body unit 10a from a polarity of the second metal package body unit 10b.

The first insulating member 42 may include any one of various materials having an insulation function. As an example, the first insulating member 42 may include a resin, such as polyimide (PI), but the present disclosure is not limited thereto. A thickness of the first insulating member 42 may range from 10 µm to 100 µm. When the thickness of the first insulating member 42 is 10 µm or more, the first metal package body unit 10a may be sufficiently insulated from the second metal package body unit 10b. When the thickness of the first insulating member 42 is 100 µm or less, a problem of increasing the size of a package may be reduced.

The body 10 may include a cavity 11, which is concave in a first direction from a top surface of the body 10 toward a bottom surface 12 thereof. Further, the body 10 may include a first alignment mark 15a and a second alignment mark 15b, which are disposed on the top surface of the body 10. The first alignment mark 15a may have a different shape from that of the second alignment mark 15b. As an example, the first alignment mark 15a may have a triangular shape, and the second alignment mark 15b may have a tetragonal shape, but the present disclosure is not limited thereto.

The body 10 may be disposed on a resin unit 410. The resin unit 410 may be disposed along a corner region between an outer side surface and the bottom surface of the body 10. According to an exemplary embodiment, since the resin unit 410 is disposed under the body 10, occurrence of burrs may be reduced during a package cutting process.

The first insulating member 42 may be formed through at least two outer side surfaces of a plurality of outer side surfaces of the body 10 having conductivity and a bottom surface of the cavity 11. Accordingly, the first insulating member 42 may be exposed at the outer side surface of the body 10.

The outer side surface of the body 10 having conductivity, an outer side surface of the resin unit 410, and an exposed surface of the first insulating member 42 may all be coplanar with each other. That is, the outer side surface of the resin unit 410 and the exposed surface of the first insulating member 42 may form one vertical surface with the outer side surface of the body 10 having conductivity.

The first metal package body unit 10a may be disposed to face the second metal package body unit 10b and include a first inner side surface S14 on which the first insulating member 42 is disposed between the first and second metal package body units 10a and 10b, and first to third, first outer side surfaces S11, S12, and S13 that constitute a side surface of the first metal package body unit 10a. The first inner side surface S14 may be a first adhesive surface that is in contact with the first insulating member 42.

The second metal package body unit 10b may be disposed to face the first metal package body unit 10a and include a second inner side surface S24 on which the first insulating member 42 is disposed between the first and second metal package body units 10a and 10b and first to third, second outer side surfaces S21, S22, and S23 that constitute the side surface of the second metal package body unit 10b. The second inner side surface S24 may be a second adhesive surface that is in contact with the first insulating member 42.

Referring to FIGS. 3 and 4, the cavity 11 may be disposed in the top surface of the body 10 and have a bottom surface 11c and an inclined surface 11d. Since the first insulating member 42 is formed through two opposite outer side surfaces of the body 10, the first insulating member 42 may be exposed at the bottom surface 11c and the inclined surface 11d of the cavity 11.

The inclined surface 11d of a first cavity 11a may be disposed in a vertical direction to the bottom surface 11c thereof. However, the present disclosure is not limited thereto, and the inclined surface 11d may be inclined at an angle larger than 90° with the bottom surface 11c so that light emitted by the semiconductor device 100 may be reflected upward. As described above, since the body 10 is manufactured using aluminum, even if an additional reflective member is not provided, an inner surface of the cavity 11 may reflect light having a UV wavelength band upward.

A second cavity 11b may be disposed on the first cavity 11a and has such a diameter as to dispose the light-transmissive member 50. The light-transmissive member 50 may be supported by a step unit 15 between the first cavity 11a and the second cavity 11b. The second cavity 11b may include a plurality of recesses 17, which may protrude toward corners of the body 10 at an outer circumferential surface of the second cavity 11b.

The body 10 may include first and second grooves 14a and 14b, which are disposed at corners where the bottom surface 12 of the body 10 meets a side surface 13 of the body 10, and a second insulating member 41 disposed in the first and second grooves 14a and 14b. The first and second grooves 14a and 14b may be wholly disposed along corner regions where the bottom surface 12 of the body 10 meets the side surface 13 thereof.

Specifically, the body 10 may include the first groove 14a, which is disposed in a region where a bottom surface 12a of the first metal package body unit 10a meets the first to third, first outer side surfaces S11, S12, and S13, and the second groove 14b, which is disposed in a region where the bottom surface 12b of the second metal package body unit 10b meets the first to third, second outer side surfaces S21, S22, and S23.

The second insulating member 41 may include a 2-1^{st} insulation unit 41a disposed in the first groove 14a and a 2-2^{nd} insulation unit 41b disposed in the second groove 14b. In this case, the 2-1^{st} insulation unit 41a may be integrally formed with the 2-2^{nd} insulation unit 41b.

Shapes of the first groove 14a and the second groove 14b are not specifically limited. A sectional shape of the first groove 14a and the second groove 14b may include any one of a polygonal shape, a lens shape, and the like.

The second insulating member 41 may be formed of the same material as the first insulating member 42. The first insulating member 42 and the second insulating member 41 may be formed of one selected from a modified epoxy resin composition, such as an epoxy mold compound (EMC), white silicone, photoimageable solder resist (PSR), a silicone resin composition, a silicone modified epoxy resin, and the like, a modified silicone resin composition, such as an epoxy-modified silicone resin and the like, and a resin such as a polyimide resin composition, a modified polyimide resin composition, polyphthalamide (PPA), a polycarbonate resin, a polyphenylene sulfide (PPS), a liquid crystal polymer (LCP), an acrylonitrile butadiene styrene (ABS) resin, a phenol resin, an acryl resin, a polybutylene terephthalate (PBT) resin, and the like.

However, the present disclosure is not limited thereto, and a material for the first insulating member 42 may be different from a material for the second insulating member 41. As an example, the first insulating member 42 may include a polyimide (PI)-based adhesive material. Accordingly, the first insulating member 42 may include a material having a higher heat resistance than that of the second insulating member 41.

In this case, the first insulating member 42 may be prevented from breaking or cracking even in a high-temperature high-pressure environment, which is produced during the formation of the first insulating member 42, or in a high-temperature environment of about 320 °C which is produced during a die-bonding process such as a eutectic process, a silver (Ag) paste process, and the like.

According to the embodiment, since the second insulating member 41 is disposed at lower corners of the body 10, burrs may be prevented from occurring at the corners of the body 10 during a package cutting process. Since an aluminum substrate includes a metal material, burrs may easily occur in the aluminum substrate during a cutting process. When the burrs occur, the bottom surface 12 of the body 10 may not be flat such that the semiconductor device package may be poorly mounted on a circuit substrate. Further, when the burrs occur, a thickness of the body 10 may be non-uniform, and a partial region of the body 10 may be lifted which may cause measurement errors. Since the second insulating member 41 is formed of an insulating material, burrs may not be easily generated during a cutting process.

Inner surfaces of the first groove 14a and the second groove 14b may have roughness (not shown). When the inner surfaces of the first and second grooves 14a and 14b are smooth, adhesion of the first and second grooves 14a and 14b with the second insulating member 41 may be weak. Accordingly, the inner surfaces of the first and second grooves 14a and 14b may have roughness through a surface treatment process to fix the second insulating member 41.

A first-directional thickness (Y-directional width or d1) of the second insulating member 41 may range from 50 µm to 150 µm. A first direction (or Y direction) may be a direction from the bottom surface 12 of the body 10 toward the top surface thereof. When the first-directional thickness d1 of the second insulating member 41 is 50 µm or more, a sufficient thickness may be ensured to prevent occurrence of burrs during a package cutting process. When the first-directional thickness d1 of the second insulating member 41 is 150 µm or less, the second insulating member 41 may be prevented from protruding from the bottom surface 12 of the body 10.

A second-directional width (X-directional width w1) of the second insulating member 41 may range from 100 µm to 300 µm. A second direction (or X direction) may be a direction orthogonal to the first direction. When the second-directional width w1 of the second insulating member 41 is 100 µm or more, the second insulating member 41 may be sufficiently fixed to the first groove 14a and the second groove 14b. When the second-directional width w1 of the second insulating member 41 is 300 µm or less, the bottom surface 12 of the body 10 may ensure a sufficient area for an electrode to be mounted thereon.

According to the exemplary embodiment, a ratio d1:w1 of the thickness d1 of the second insulating member 41 to the width w1 thereof may range from 1:1.5 to 1:6. That is, the width w1 of the second insulating member 41 may be greater than the thickness d1 thereof. When the above-described ratio d1:w1 is satisfied, the second insulating member 41 may be sufficiently fixed to the first and second grooves 14a and 14b to inhibit occurrence of burrs.

The body 10 may include a third groove 19a disposed in a region where the bottom surface 12a of the first metal package body unit 10a meets the first inner side surface S14, . a fourth groove 19b disposed in a corner region where the bottom surface 12b of the second metal package body unit 10b meets the second inner side surface S24, and a third insulating member 43 disposed in the third groove 19a and the fourth groove 19b.

The third insulating member 43 may be disposed in the bottom surface 12 of the body 10 and connected to the second insulating member 41 and the first insulating member 42. Further, the third insulating member 43 may overlap the first insulating member 42 in the first direction (Y direction). In this case, a length of the first insulating member 42 may be greater than a length of the third insulating member 43 in the first direction (Y direction).

The first to fourth grooves 14a, 14b, 19a, and 19b may be formed at the same time. Further, the second insulating member 41 and the third insulating member 43 may be formed using one coating process. Accordingly, a material for the third insulating member 43 may be the same as a material for the second insulating member 41, but the present disclosure is not limited thereto.

The bottom surface 12a of the first metal package body unit 10a, the bottom surface 12b of the second metal package body unit 10b, a bottom surface of the second insulating member 41, and a bottom surface of the third insulating member 43 may be coplanar with each other. That is, the second insulating member 41 and the third insulating member 43 may not protrude from the bottom surface 12 of the body 10 but entirely form a planar surface. Accordingly, when the semiconductor device package is mounted on a circuit substrate, a failure rate may be reduced, and a thickness of a package may be reduced.

A thickness (Y-directional width or d2) of the third insulating member 43 may range from 10 µm to 100 µm. When the thickness of the third insulating member 43 is 10 µm or more, the third insulating member 43 may be tightly fixed to the third and fourth grooves 19a and 19b. When the thickness of the third insulating member 43 is 100 µm or less, the third and fourth grooves 19a and 19b may be controlled to have a small depth so that a thickness of a region in which the semiconductor device 100 is mounted may be ensured. The region in which the semiconductor device 100 is mounted may be a thinnest region of the body 10 because the cavity 11 is formed in the region in which the semiconductor device 100 is mounted. Thus, it may be advantageous to form the third and fourth grooves 19a and 19b to be as shallow as possible.

A width (X-directional width or w2) of the third insulating member 43 may range from 300 µm to 700 µm. When the width w2 of the third insulating member 43 is 300 µm or more, the bottom surface 12a of the first metal package body unit 10a may be sufficiently spaced apart from the bottom surface 12b of the second metal package body unit 10b so as to prevent occurrence of a short. When the width w2 of the third insulating member 43 is 700 µm or less, the bottom surface 12 of the body 10 may ensure a sufficient area for mounting an electrode. Accordingly, the width w2 of the third insulating member 43 may be greater than the width w1 of the second insulating member 41.

The thickness d1 of the second insulating member 41 may be greater than the thickness d2 of the third insulating member 43. The region in which the semiconductor device 100 is mounted may be the thinnest region of the body 10 because the cavity 11 is formed in the region in which the semiconductor device 100 is mounted. Thus, it may be advantageous to form the third and fourth grooves 19a and 19b to be as shallow as possible. Further, the second insulating member 41 may have a predetermined thickness to prevent occurrence of burrs. As a result, when the thickness d1 of the second insulating member 41 is greater than the thickness d2 of the third insulating member 43, occurrence of burrs may be effectively prevented, and a sufficient strength of the package may be ensured.

However, the present disclosure is not limited thereto, and a thickness d1 of the second insulating member 41 may be equal to a thickness d2 of the third insulating member 43.

Since the body 10 has conductivity as described above, each of the bottom surface 12a of the first metal package body unit 10a and the bottom surface 12b of the second metal package body unit 10b may have conductivity. In this case, the second insulating member 41 may be disposed along the corners of the body 10 and surround the bottom surface 12a of the first metal package body unit 10a and the bottom surface 12b of the second metal package body unit 10b, and the third insulating member 43 may be disposed between the bottom surface 12a of the first metal package body unit 10a and the bottom surface 12b of the second metal package body unit 10b. Both ends of the third insulating member 43 in a lengthwise direction may be in contact with the second insulating member 41.

The bottom surface 12a of the first metal package body unit 10a may have an area greater than that of the bottom surface 12b of the second metal package body unit 10b. A ratio of an area of the bottom surface 12a of the first metal package body unit 10a to an area of the bottom surface 12b of the second metal package body unit 10b may range from 1:0.2 to 1:0.6. When the above-described area ratio is 1:0.2 or more, the area of the bottom surface 12b of the second metal package body unit 10b may be ensured to be sufficient to prevent occurrence of a short. When the above-described area ratio is 1:0.6 or less, a sufficient space for disposing a sub-mount on the bottom surface 12a of the first metal package body unit 10a may be ensured.

A ratio w1:w4 of the width w1 of a bottom surface of the first groove 14a to a width w4 of the bottom surface 12a of the first metal package body unit 10a may range from 1:3 to 1:5. When the ratio w1:w4 is 1:3 or more, an area of the bottom surface 12a of the first metal package body unit 10a may increase so that a sufficient area for mounting the sub-mount may be ensured. When the ratio w1:w4 is 1:5 or less, a width of the second insulating member 41 may increase so that occurrence of burrs may be effectively inhibited.

A ratio w21:w1 of a width w21 of a bottom surface of the fourth groove 19b to the width w1 of the bottom surface of the first groove 14a may range from 1:0.8 to 1:1.2. That is, the width w2 of the third insulating member 43 may be at least twice the width w1 of the second insulating member 41 Accordingly, the bottom surface 12a of the first metal package body unit 10a may be sufficiently spaced apart from the bottom surface 12b of the second metal package body unit 10b so that occurrence of a short may be prevented.

A fourth insulating member 44 may be disposed on the top surface of the body 10. The fourth insulating member 44 may be formed of the same material as, or a different material from, the first and second insulating members 42 and 41. A thickness of the fourth insulating member 44 may be smaller than that of the second insulating member 41.

The semiconductor device 100 may be disposed inside the cavity 11. The semiconductor device 100 may be electrically connected to the first metal package body unit 10a and the second metal package body unit 10b. A sub-mount 22 may be disposed in the cavity 11, and the semiconductor device 100 may be disposed on the sub-mount 22. A pad unit (not shown) to which a wire is bonded may be disposed on a bottom surface of the cavity 11.

The semiconductor device 100 may output light having a UV wavelength band. As an example, the semiconductor device 100 may output light UV-A having a near-UV wavelength band, output light UV-B having a far-UV wavelength band, or output light UV-C having a deep-UV wavelength band. A wavelength range of the semiconductor device 100 may be determined by an Al content of an emission structure 160.

In an example, the light UV-A having the near-UV wavelength band may have a peak wavelength in a range of 320 nm to 390 nm, the light UV-B having the far-UV wavelength band may have a peak wavelength in a range of 280 nm to 320 nm, and the light UV-C having the deep-UV wavelength band may have a peak wavelength in a range of 100 nm to 280 nm.

The light-transmissive member 50 may be disposed on the cavity 11. The light-transmissive member 50 may be supported by the step unit 15 disposed between the first cavity 11a and the second cavity 11b. An adhesive layer (not shown) may be disposed between the step unit 15 and the light-transmissive member 50. When the adhesive layer is excessively filled, the remaining adhesive may move back into a recess 17. Accordingly, even if the adhesive is excessively coated, the light-transmissive member 50 may be maintained to be level.

A material for the light-transmissive member 50 is not specifically limited and may be any material capable of transmitting light having a UV wavelength band. As an example, the light-transmissive member 50 may include an optical material (e.g., quartz) having a high UV-wavelength transmittance, but the present disclosure is not limited thereto.

Referring to FIG. 5, the body 10 may be disposed on the resin unit 410. That is, a top surface 410a of the resin unit 410 may be in contact with the bottom surface of the first groove 14a. The resin unit 410 may include a first through hole 411 and a second through hole 412, which may be formed through the top surface 410a and a bottom surface 410b of the resin unit 410.

The body 10 may include a first protrusion 12a-1, which protrudes from the bottom surface of the first groove 14a and is disposed in the first through hole 411, and a second protrusion 12b-1, which protrudes from the bottom surface of the second groove 14b and is disposed in the second through hole 412. Accordingly, the bottom surface 12a of the first protrusion 12a-1, the bottom surface 12b of the second protrusion 12b-1, and the bottom surface 410b of the resin unit 410 may be coplanar with each other. The first and second protrusions 12a-1 and 12a-2 may include the same aluminum material as that of the body 10.

The first through hole 411 may be larger than the second through hole 412. Accordingly, a size of the first protrusion 12a-1 may be larger than that of the second protrusion 12b-1.

A ratio of an area of the first protrusion 12a-1 to an area of the second protrusion 12b-1 may range from 1:0.2 to 1:0.6. When the area ratio is 1:0.2 or more, the area of the second protrusion 12b-1 may be ensured to be sufficient to prevent occurrence of a short. When the area ratio is 1:0.6 or less, a sufficient space for disposing a sub-mount on the first protrusion 12a-1 may be ensured.

A distance W2 between the first protrusion 12a-1 and the second protrusion 12b-1 may be greater than a width of the first insulating member 42. Accordingly, a width of the third insulating member 43 disposed between the first protrusion 12a-1 and the second protrusion 12b-1 may be increased to prevent occurrence of a short.

The first metal package body unit 10a may include a first recess unit 11-1 of which a thickness is reduced in a direction (X2 direction) toward the second metal package body unit 10b, and in which the first groove 14a and the third groove 19a are formed at the corner regions where the first to third, first outer side surfaces S11, S12, and S13 and the first inner side surface S14 of the first metal package body unit 10a meet the bottom surface 12a thereof.

The second metal package body unit 10b may include a second recess unit 11-2 of which a thickness is reduced in a direction (X1 direction) toward the first metal package body unit 10a, and in which the second groove 14b and the fourth groove 19b are formed at the corner regions where the first to third, second outer side surfaces S21, S22, and S23 and the second inner side surface S24 of the second metal package body unit 10b meet the bottom surface 12b thereof. Top surfaces of the first recess unit 11-1, the second recess unit 11-2, and the first insulating member 42 may form the cavity 11 of the body 10.

The first groove 14a and the third groove 19a of the first metal package body unit 10a may include the first groove 14a, which is disposed in a region where the bottom surface 12a of the first metal package body unit 10a meets the first to third, first outer side surfaces S11, S12, and S13 of the first metal package body unit 10a, and the third groove 19a, which is disposed in a region where the bottom surface 12a of the first metal package body unit 10a meets the first inner side surface S14 of the first metal package body unit 10a.

The second groove 14b and the fourth groove 19b of the second metal package body unit 10b may include the second groove 14b, which is disposed in a region where the bottom surface 12b of the second metal package body unit 10b meets the first to third, second outer side surfaces S21, S22, and S23, and the fourth groove 19b, which is disposed in a region where the bottom surface 12b of the second metal package body unit 10b meets the second inner side surface S24 . of the second metal package body unit 10b. In this case, the third groove 19a may be connected to the fourth groove 19b.

The resin unit 410 may include the second insulating member 41, which is disposed in the first groove 14a and the second groove 14b, and the third insulating member 43, which is disposed in the third groove 19a and the fourth groove 19b. Accordingly, the resin unit 410 may include all the above-described characteristics of the second insulating member 41 and the third insulating member 43.

That is, a thickness of the second insulating member 41 may be greater than a thickness of the third insulating member 43, and a width of the second insulating member 41 may be smaller than a width of the third insulating member 43.

In addition, a material for the second insulating member 41 and the third insulating member 43 may be different from a material for the first insulating member 42.

A width W1 of the second insulating member 41 b may be smaller than a width W5 of the top surface of the body 10. The width W1 of the second insulating member 41 may range from 50% to 90% of the width W5 of the top surface of the body 10. Due to the above-described structure, a sufficient area for mounting an electrode under the body 10 may be ensured and a sufficient width of the second insulating member 41 may be ensured, thereby obtaining an adhesion of the second insulating member 41 with the body 10.

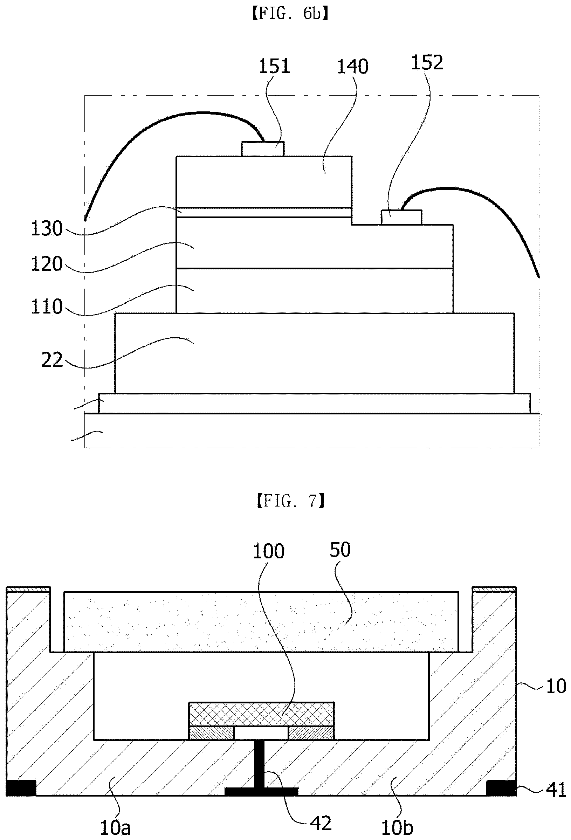

FIG. 6A is a conceptual diagram of a semiconductor device 100 according to an exemplary embodiment of the present disclosure, and FIG. 6B illustrates a modified example of FIG. 6A.

Referring to FIG. 6A, the semiconductor device 100 according to the exemplary embodiment may be mounted as a flip-chip type on a sub-mount 22. That is, a first electrode 152 and a second electrode 151 of the semiconductor device 100 may be mounted as a flip-chip type on a first pad 23a and a second pad 23b of the sub-mount 22. In this case, each of the first pad 23a and the second pad 23b may be soldered to the body 10 using wires W.

However, a method of mounting the semiconductor device 100 is not specifically limited. For example, as shown in FIG. 6B, a substrate 110 of the semiconductor device 100 may be disposed on the sub-mount 22, and the first electrode 152 and the second electrode 151 may be directly soldered to the body 10.

The semiconductor device 100 according to the exemplary embodiment may include a substrate 110, a first-conductivity-type semiconductor layer 120, an active layer 130, and a second-conductivity-type semiconductor layer 140. Each of the first-and second-conductivity-type semiconductor layers 120 and 140 may include an aluminum composition to emit light having a UV wavelength band.

The substrate 110 may include a conductive substrate or an insulating substrate. The substrate 110 may include a material suitable for growing a semiconductor material or being a carrier wafer. The substrate 110 may be formed of a material selected from sapphire (Al₂O₃), silicon carbide (SiC), gallium arsenide (GaAs), gallium nitride (GaN), zinc oxide (ZnO), silicon (Si), gallium phosphide (GaP), indium phosphide (InP), and germanium (Ge), but the present disclosure is not limited thereto. The substrate 110 may be removed when necessary.

A buffer layer (not shown) may be further provided between the first-conductivity-type semiconductor layer 120 and the substrate 110. The buffer layer may reduce lattice mismatch between an emission structure 160 provided on the substrate 110 and the substrate 110.

The first-conductivity-type semiconductor layer 120 may be implemented as a compound semiconductor, such as a Group III-V compound semiconductor or a Group II-VI compound semiconductor, and a first dopant may be doped into the first-conductivity-type semiconductor layer 120. The first-conductivity-type semiconductor layer 120 may be selected out of semiconductor materials (e.g., GaN, AlGaN, InGaN, and InAlGaN) having a composition formula of Inₓ₁Al_{y1}Ga_{1-x1-y1}N(0≤x1≤1, 0≤y1≤1, 0≤x1+y1≤1). Further, the first dopant may be an n-type dopant, such as silicon (Si), germanium (Ge), tin (Sn), selenium (Se), and tellurium (Te). When the first dopant is the n-type dopant, the first-conductivity-type semiconductor layer 120 doped with the first dopant may be an n-type semiconductor layer.

The active layer 130 may be a layer in which electrons (or holes) injected through the first-conductivity-type semiconductor layer 120 meet holes (or electrons) injected through the second-conductivity-type semiconductor layer 140. As the electrons and the holes transition to a low energy level due to recombination therebetween, the active layer 130 may generate light having a wavelength corresponding to the energy difference.

The active layer 130 may have any one of a single well structure, a multiple well structure, a single quantum well (SQW) structure, a multiple quantum well (MQW) structure, a quantum dot structure, or a quantum wire structure, and the structure of the active layer 130 is not limited thereto.

The second-conductivity-type semiconductor layer 140 may be formed on the active layer 130 and implemented as a compound semiconductor, such as a Group III-V compound semiconductor or a Group II-VI compound semiconductor, and a second dopant may be doped into the second-conductivity-type semiconductor layer 140. The second-conductivity-type semiconductor layer 140 may be formed of a semiconductor material having a composition formula of Inₓ₅Al_{y2}Ga_{1-x5-y2}N (0≤x5≤1, 0≤y2≤1, 0≤x5+y2≤1) or a material selected out of aluminum indium nitride (AlInN), aluminum gallium arsenide (AlGaAs), gallium phosphide (GaP), gallium arsenide (GaAs), gallium arsenide phosphide (GaAsP), and aluminum gallium indium phosphide (AlGaInP). When the second dopant is a p-type dopant, such as magnesium (Mg), zinc (Zn), calcium (Ca), strontium (Sr), and barium (Ba), the second-conductivity-type semiconductor layer 140 doped with the second dopant may be a p-type semiconductor layer.

The first electrode 152 may be electrically connected to the first-conductivity-type semiconductor layer 120, and the second electrode 151 may be electrically connected to the second-conductivity-type semiconductor layer 140. The first and second electrodes 152 and 151 may be formed of one selected from titanium (Ti), ruthenium (Ru), rhodium (Rh), iridium (Ir), magnesium (Mg), zinc (Zn), aluminum (Al), indium (In), tantalum (Ta), palladium (Pd), cobalt (Co), nickel (Ni), silicon (Si), germanium (Ge), silver (Ag), gold (Au), and a selected alloy thereof.

Although the exemplary embodiment illustrates a structure of a horizontal light-emitting device, the present disclosure is not limited thereto. For example, the light-emitting device according to the exemplary embodiment may have a vertical structure or a flip-chip structure.

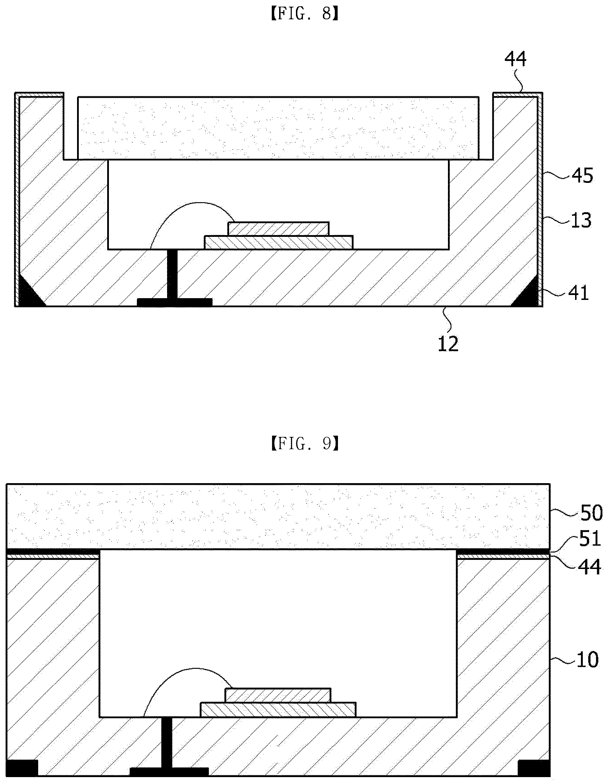

FIG. 7 is a cross-sectional view of a semiconductor device package according to another exemplary embodiment of the present disclosure. FIG. 8 is a cross-sectional view of a semiconductor device package according to still another exemplary embodiment of the present disclosure. FIG. 9 illustrates a modified example of FIG. 1.

Referring to FIG. 7, a first insulating member 42 may be disposed in the center of a bottom surface 12 of a body 10. A position of the first insulating member 42 may be freely changed in a structure from which a sub-mount is omitted. In this case, a first metal package body unit 10a and a second metal package body unit 10b may have shapes that are symmetrical to each other.

Referring to FIG. 8, a thickness of a second insulating member 41 may be reduced away from a side surface 13 of the body 10. According to the above-described configuration, since the second insulating member 41 has a great thickness on the side surface 13 of the body 10, occurrence of burrs may be effectively inhibited during a package cutting process. Further, a bottom surface 12 of the body 10 may be maximally ensured so that a sufficient area of the bottom surface 12 of the body 10 for an electrode to be mounted thereon may be ensured. However, the present disclosure is not limited thereto, and the thickness of the second insulating member 41 may not be continuously reduced but may be reduced in a staircase form away from the side surface 13 of the body 10.

A fifth insulating member 45 may be disposed on the side surface 13 of the body 10.
The fifth insulating member 45 may be connected to the fourth insulating member 44 disposed on the top surface of the body 10. Since the body 10 according to the embodiment is formed of aluminum, the body 10 may be vulnerable to electrostatic discharge (ESD). The fourth insulating member 44 and the fifth insulating member 45 may be disposed on an outer surface of the body 10 and protect an outer appearance of the body 10 and prevent ESD and a short.

The fifth insulating member 45 may have a thickness of 10 µm to 100 µm. When the thickness of the fifth insulating member 45 is less than 10 µm, it may be difficult to ensure sufficient insulation of the outer surface of the body 10. When the thickness of the fifth insulating member 45 is more than 100 µm, there is a problem in that a size of the package may increase.

However, the present disclosure is not limited thereto, and the fifth insulating member 45 may be formed by oxidizing the outer surface of the body 10. A method of oxidizing the outer surface of the body 10 is not specifically limited. As an example, the outer surface of the body 10 may be oxidized by supplying oxygen into a chamber. However, the present disclosure is not limited thereto, and various surface treatment techniques for oxidizing a surface of aluminum may be applied.

In this case, an inner surface and a bottom surface of the body 10 may be processed with a mask to prevent oxidation.

The bottom surface and the inner surface of the body 10 may function as a channel for supplying current to the semiconductor device 100. Further, when an inner surface of the cavity 11 is oxidized, a reflectance for UV light may be reduced.

Referring to FIG. 9, a light-transmissive member 50 may be disposed on a top surface of a body 10. In this case, when the light-transmissive member 50 is directly disposed on the top surface of the body 10, the light-transmissive member 50 may not be easily adhered to the top surface of the body 10, because the top surface of the body 10 has relatively low roughness. Therefore, according to the embodiment, a fourth insulating member 44 may be formed on the top surface of the body 10 to increase roughness, and the fourth insulating member 44 may be coated with an adhesive 51 to fix the light-transmissive member 50 thereon. However, the present disclosure is not limited thereto, and the fourth insulating member 44 may be omitted.

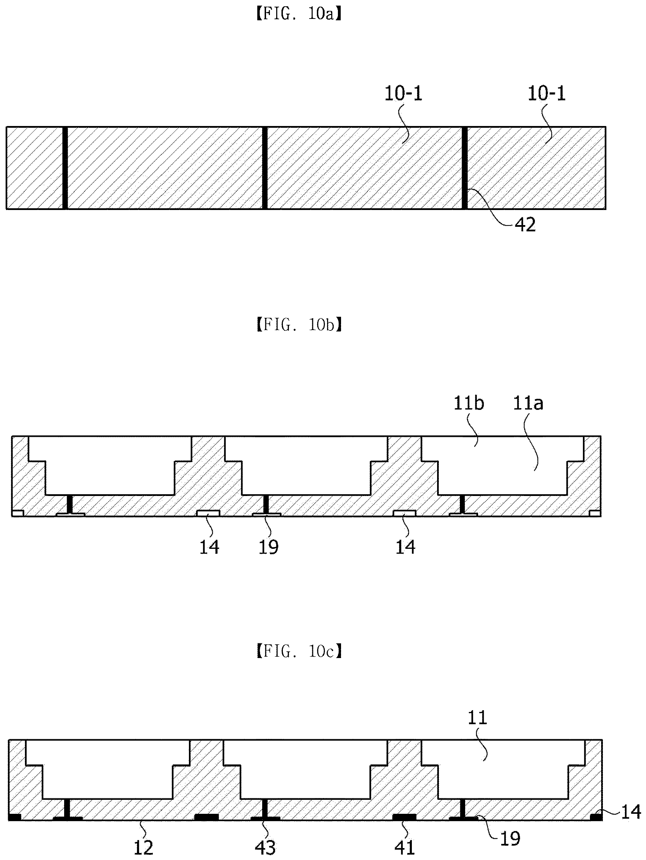

FIGS. 10A to 10E are diagrams illustrating a process of manufacturing a semiconductor device package according to an exemplary embodiment of the present disclosure.

Referring to FIG. 10A, spaces among a plurality of aluminum substrates 10-1 may be coated with a first insulating member 42 so that the plurality of aluminum substrates 10-1 may be bonded to each other. The first insulating member 42 may include any one of various materials having an insulation function. A thickness of the first insulating member 42 may range from 10 µm to 100 µm. When the thickness of the first insulating member 42 is 10 µm or more, the plurality of aluminum substrates 10-1 may be sufficiently insulated from each other. When the thickness of the first insulating member 42 is 100 µm or less, a problem of increasing the size of a package may be reduced.

Referring to FIG. 10B, a plurality of cavities 11 may be formed in the plurality of aluminum substrates 10-1. A first cavity 11a in which a semiconductor device is to be disposed and a second cavity 11b in which a light-transmissive member 50 is to be disposed may be formed together. A method of forming the cavities 11 is not specifically limited. As an example, any typical metal processing method may be applied.

In this case, a plurality of grooves 14, 19 may be formed in a bottom surface 12 of the aluminum substrates 10-1. Thereafter, referring to FIG. 10C, the plurality of grooves 14, 19 may be coated with a second insulating member 41 and a third insulating member 43. In this case, processes may be simplified, and the second insulating member 41 may be integrally formed with the third insulating member 43 to ensure excellent adhesion.

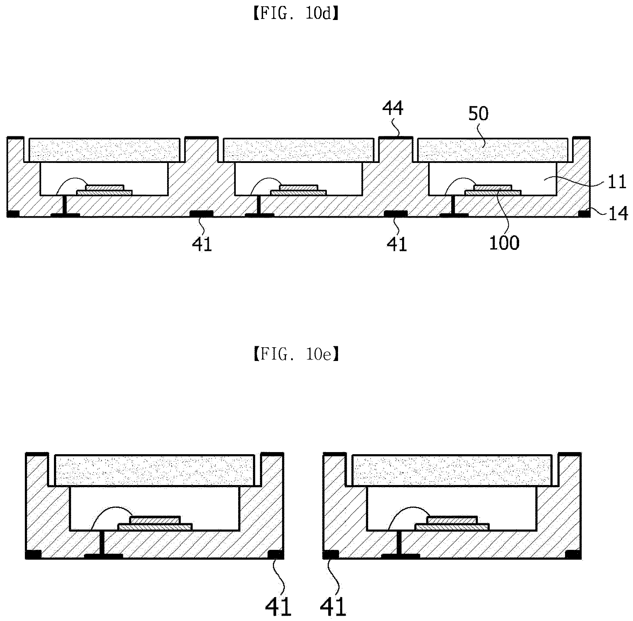

Referring to FIG. 10D, a semiconductor device 100 may be mounted inside a cavity 11, and a light-transmissive member 50 may be disposed on and fixed to the semiconductor device 100. The light-transmissive member 50 may be fixed to the semiconductor device 100 using an additional adhesive.

The semiconductor device 100 may be disposed inside the cavity 11. A sub-mount may be disposed in the cavity 11, and the semiconductor device 100 may be disposed on the sub-mount. A pad unit (not shown) to which a wire is bonded may be disposed on a bottom surface of the cavity 11.

The semiconductor device 100 may output light having a UV wavelength band. As an example, the semiconductor device 100 may output light UV-A having a near-UV wavelength band, output light UV-B having a far-UV wavelength band, or output light UV-C having a deep-UV wavelength band. A wavelength range may be determined by an aluminum (Al) content of an emission structure 160.

A material for the light-transmissive member 50 is not specifically limited and may be any material capable of transmitting light having a UV wavelength band. As an example, the light-transmissive member 50 may include an optical material (e.g., quartz) having a high UV-wavelength transmittance, but the present disclosure is not limited thereto.

Subsequently, a fourth insulating member 44 may be formed on a top surface of the aluminum substrates 10-1.

A thickness of the fourth insulating member 44 is not specifically limited.
Further, a fifth insulating member may be formed on a side surface 13 of a body 10 as described further below with regards to FIG. 10E when necessary.

The first to fifth insulating members 41, 42, 43, 44, and 45 according to the exemplary embodiment may be formed of a modified epoxy resin composition, such as an EMC, white silicone, PSR, a silicone resin composition, a silicone modified epoxy resin, and the like, a modified silicone resin composition, such as an epoxy-modified silicone resin and the like, and a resin such as a polyimide resin composition, a modified polyimide resin composition, PPA, a polycarbonate resin, a PPS, an LCP, an ABS resin, a phenol resin, an acryl resin, a PBT resin, and the like. However, the present disclosure is not limited thereto.

Referring to FIG. 10E, the plurality of aluminum substrates 10-1 may be cut into a plurality of pieces to manufacture a plurality of packages. In this case, a cut surface may pass through a region in which the second insulating member 41 is disposed. As described above, since the second insulating member 41 is disposed at an end of the body 10, occurrence of burrs may be inhibited during the cutting process.

A semiconductor device may be applied to various kinds of light source devices. As an example, light source devices may be interpreted as including a sterilizing device, a curing device, a lighting device, a display device, a vehicle lamp, and the like. That is, the semiconductor device may be applied to various electronic devices disposed in cases and configured to provide light.

A sterilizing device may include a semiconductor device package according to an exemplary embodiment and sterilize a desired region. The sterilizing device may be applied to home appliances, such as a water purifier, an air-conditioner, a refrigerator, and the like, but the present disclosure is not limited thereto. That is, the sterilizing device may be applied to any one of various products (e.g., medical equipment) that need to be sterilized.

In an example, a water purifier may include a sterilizing device according to an exemplary embodiment to sterilize circulating water. The sterilizing device may be disposed at a nozzle or outlet through which water circulates and emit UV light. In this case, the sterilizing device may include a waterproof structure.

A curing device may include a semiconductor device package according to an exemplary embodiment, and the curing device may cure various kinds of liquids. Liquids may be the broadest concept that encompasses a variety of materials that may be cured with UV irradiation. For example, the curing device may cure various kinds of resins. Alternatively, the curing device may be used to cure cosmetic products, such as manicures.

A lighting device may include a light source module including a substrate and a semiconductor device package according to an exemplary embodiment, a heat radiation unit configured to radiate heat of the light source module, and a power supply unit configured to process or convert an electric signal provided from the outside and provide the processed or converted electric signal to the light source module. Further, the lighting device may include a lamp, a head lamp, a street lamp, or the like.

A display device may include a bottom cover, a reflection plate, a light-emitting module, a light guide plate (LGP), an optical sheet, a display panel, an image signal output circuit, and a color filter. The bottom cover, the reflection plate, the light-emitting module, the LGP, and the optical sheet may constitute a backlight unit (BLU).

The reflection plate may be disposed on the bottom cover, and the light-emitting module may emit light. The LGP may be disposed in front of the reflection plate and guide light emitted by the light-emitting module forward. The optical sheet may include a prism sheet and may be disposed in front of the LGP. The display panel may be disposed in front of the optical sheet, and the image signal output circuit may supply an image signal to the display panel. The color filter may be disposed in front of the display panel.

When the semiconductor device is used as a BLU of a display device, the semiconductor device may be used as an edge-type BLU or a direct-light-type BLU.

In addition to the above-described light-emitting diode (LED), the semiconductor device may be a laser diode (LD).

Like a light-emitting diode, the LD may include the first-conductivity-type semiconductor layer, the active layer, and the second-conductivity-type semiconductor layer, which have the above-described structures. Further, the LD may use an electroluminescence phenomenon where light is emitted when a p-type first-conductivity-type semiconductor is bonded to an n-type second-conductivity-type semiconductor and current is supplied. However, the LD may differ from the light-emitting diode in terms of directionality and phase of the emitted light. That is, the LD may emit light having one specific wavelength (or monochromatic light) at the same phase in the same direction by using a stimulated emission phenomenon and a constructive interference phenomenon. Due to the above-described characteristics of the LD, the LD may be used for optical communications, medical equipment, semiconductor process equipment, and the like.

Examples of a light-receiving element may include a photodetector, which is a kind of transducer configured to detect light and convert an intensity of the light into an electric signal. Photodetectors may include photocells (silicon, selenium), a photo resistor (cadmium sulfide, cadmium selenide), photodiodes (PDs) (e.g., PDs having peak wavelengths in visible blind spectral regions or true blind spectral regions), phototransistors, photo multiplier tubes (PMTs), photoelectric tubes (vacuum, gas filled), infrared (IR) detectors, and the like, but the embodiment is not limited thereto.

In addition, semiconductor devices, such as photodetectors, typically may be manufactured using a direct-bandgap semiconductor having excellent light conversion efficiency. Alternatively, the photodetectors may have various structures and typically include a pinned photodetector using a p-n junction, a Schottky photodetector using a Schottky junction, a metal-semiconductor-metal (MSM) photodetector, and the like.

A PD may include the first-conductivity-type semiconductor layer, the active layer, and the second-conductivity-type semiconductor layer, which have the above-described structures like the light-emitting diode, and have a p-n junction or a pin structure. The PD may operate with application of a reverse bias or a zero bias. When light is incident to the PD, electrons and holes may be generated and current may flow. In this case, a magnitude of the current may be approximately proportional to an intensity of light incident to the PD.

A photocell or a solar cell, which is a kind of the PD, may convert light into current. The solar cell may include the first-conductivity-type semiconductor layer, the active layer, and the second-conductivity-type semiconductor layer, which, like the light-emitting diode, have the above-described structures.

In addition, the semiconductor device may be used as a rectifier of an electronic circuit due to rectifying characteristics of a typical diode using a p-n junction, or may be applied to a microwave circuit and used for an oscillation circuit.

Furthermore, the above-described semiconductor device may not necessarily be formed of a semiconductor but may further include a metal material in some cases. For example, a semiconductor device, such as a light-receiving element, may be formed of at least one of silver (Ag), aluminum (Al), gold (Au), indium (In), gallium (Ga), nitrogen (N), zinc (Zn), selenium (Se), phosphorus (P), or arsenic (As), or be formed of a semiconductor material doped with a p-type or n-type dopant or an intrinsic semiconductor material.

As described above, heat radiation efficiency of a semiconductor device package can be improved.

Further, occurrence of burrs can be inhibited during a package cutting process.

In addition, light extraction efficiency can be improved.

Furthermore, a manufacturing process can be simplified, and manufacturing costs can be reduced.

Various advantages and effects of the present disclosure are not limited by the above descriptions but will be clearly understood from the description of detailed embodiments of the disclosure.

While this disclosure has been particularly shown and described with reference to exemplary embodiments thereof, it will be understood by those skilled in the art that various changes and modifications may be made thereto without departing from the scope of the present invention as defined by the appended claims. For example, each component described in detail in the embodiments may be modified and implemented. Differences related to the changes and the applications will be construed as being within the scope of the present invention as defined by the appended claims.

## Claims

1. A semiconductor device package comprising:
a resin unit (410);
a metal body including a cavity (11) disposed on the resin unit (410); and a light-emitting device disposed in the cavity (11),
wherein the metal body includes a first metal body and a second metal body, wherein an insulating member is disposed between the first metal body and the second metal body,
wherein a portion of the first metal body, a portion of the second metal body, and a portion of the insulating member are exposed to the cavity (11),
wherein the light emitting device is electrically connected to the portion of the first metal body and the portion of the second metal body, and
wherein the metal body further includes a groove (14a, 14b, 19a, 19b) in a bottom surface (12) of the metal body,
**characterized in that** the groove (14a, 14b, 19a, 19b) includes a peripheral groove and a separating groove,
wherein the separating groove is overlapped with the insulating member vertically,
wherein the peripheral groove is provided along the periphery of the metal body,
wherein the separating groove is connected to the peripheral groove at the periphery of the metal body, wherein the resin unit (410) is disposed in the separating groove and the peripheral groove, and wherein a portion of the resin unit (410) disposed in the peripheral groove has a thickness d1 greater than the thickness d2 of another portion of the resin unit (410) disposed in the separating groove.

2. The semiconductor device package of claim 1, wherein the separating groove separates the peripheral groove into a first groove (14a) in a bottom surface (12a) of the first metal body and a second groove (14b) in a bottom surface (12b) of the second metal body.

3. The semiconductor device package of claim 2, wherein the separating groove comprises a third groove (19a) disposed under the first metal body, and a fourth groove (19b) disposed under the second metal body.

4. The semiconductor device package of any one of claims 1 to 3, wherein a width of the resin unit (410) in the peripheral groove is larger than a depth of the resin unit (410) in the peripheral groove.

5. The semiconductor device package of claim 4, wherein a ratio of the depth to the width of the resin unit (410) disposed in the peripheral groove is in a range of 1:1.5 - 1:6.

6. The semiconductor device package of any one of claims 1 to 5, wherein the groove (14a, 14b, 19a, 19b) is provided with a closed-loop shape.

7. The semiconductor device package of any one of claims 1 to 6, wherein the resin unit (410) includes a first through hole (411), and a second through hole (412) spaced from the first through hole (411), wherein the first and second through holes (411, 412) are provided between the peripheral groove and the separating groove, and wherein another portion of the first metal body is disposed in the first though hole (411) and another portion of the second metal body is disposed in the second through hole (412).

8. The semiconductor device package of claim 7, wherein a first bottom width of the another portion of the first metal body is larger than a second bottom width of the another portion of the second metal body.

9. The semiconductor device package of any one of claims 1 to 7, wherein a width of the separating groove is larger than a width of the peripheral groove.

10. The semiconductor device package of any one of claims 1 to 9, wherein a height of the groove (14a, 14b, 19a, 19b) is smaller than a height between a bottom surface (11c) of the cavity (11) and the bottom surface (12) of the metal body.

11. The semiconductor device package of any one of claims 1 to 10, wherein the insulating member includes a material different from the resin unit (410)

12. The semiconductor device package of any one of claims 1 to 11, wherein a height of the peripheral groove is larger than a height of the separating groove, and wherein an outmost side surface of the resin unit (410) and an outmost side surface of the insulating member are flush with each other.

13. The semiconductor device package of any one of claims 1 to 12, wherein a light-transmissive member (50) is disposed on the metal body, wherein the light-transmissive member (50) is disposed in a region that is provided on an inner side of the peripheral groove.

14. The semiconductor device package of any one of claims 1 to 12, wherein a light-transmissive member (50) is disposed on the metal body, wherein the light-transmissive member (50) overlaps with the groove (14a, 14b, 19a, 19b)

15. The semiconductor device package of any one of claims 1 to 14, wherein the light emitting device includes a light emitting structure, a first electrode (152), a second electrode (151), and a substrate (110),
wherein the light emitting structure includes a first conductivity type semiconductor layer (120), a second conductivity type semiconductor layer (140), and an active layer (130) disposed between the first conductivity type semiconductor layer (120) and the second conductivity type semiconductor layer (140),
wherein the first electrode (152) is electrically connected to the first metal body and the first conductivity type semiconductor layer (120), and the second electrode (151) is electrically connected to the second metal body and the second conductivity type semiconductor layer (140), and
wherein the substrate (110) is disposed on the light emitting structure.

## Patentansprüche

1. Halbleiterbauelementgehäuse, umfassend:
eine Kunstharzeinheit (410);
einen Metallkörper, beinhaltend einen Hohlraum (11), angeordnet auf der Kunstharzeinheit (410); und
ein lichtemittierendes Bauelement, angeordnet in dem Hohlraum (11),
wobei der Metallkörper einen ersten Metallkörper und einen zweiten Metallkörper beinhaltet, wobei ein Isolierglied zwischen dem ersten Metallkörper und dem zweiten Metallkörper angeordnet ist,
wobei ein Anteil des ersten Metallkörpers, ein Anteil des zweiten Metallkörpers und ein Anteil des Isolierglieds zu dem Hohlraum (11) hin offen liegen,
wobei das lichtemittierende Bauelement mit dem Anteil des ersten Metallkörpers und dem Anteil des zweiten Metallkörpers elektrisch verbunden ist, und
wobei der Metallkörper ferner eine Nut (14a, 14b, 19a, 19b) in einer Bodenfläche (12) des Metallkörpers beinhaltet,
**dadurch gekennzeichnet, dass** die Nut (14a, 14b, 19a, 19b) eine Periphernut und eine Trennnut beinhaltet, wobei die Trennnut vertikal mit dem Isolierglied überlappt,
wobei die Periphernut entlang der Peripherie des Metallkörpers vorgesehen ist,
wobei die Trennnut an der Peripherie des Metallkörpers mit der Periphernut verbunden ist,
wobei die Kunstharzeinheit (410) in der Trennnut und der Periphernut angeordnet ist, und
wobei ein Anteil der Kunstharzeinheit (410), angeordnet in der Periphernut, eine Dicke d1 aufweist, die größer als eine Dicke d2 eines anderen Anteils der Kunstharzeinheit (410), angeordnet in der Trennnut, ist.

2. Halbleiterbauelementgehäuse nach Anspruch 1, wobei die Trennnut die Periphernut in eine erste Nut (14a), in einer Bodenfläche (12a) des ersten Metallkörpers, und eine zweite Nut (14b), in einer Bodenfläche (12b) des zweiten Metallkörpers, trennt.

3. Halbleiterbauelementgehäuse nach Anspruch 2, wobei die Trennnut eine dritte Nut (19a), angeordnet unter dem ersten Metallkörper, und
eine vierte Nut (19b), angeordnet unter dem zweiten Metallkörper, umfasst.

4. Halbleiterbauelementgehäuse nach einem der Ansprüche 1 bis 3, wobei eine Breite der Kunstharzeinheit (410) in der Periphernut größer als eine Tiefe der Kunstharzeinheit (410) in der Periphernut ist.

5. Halbleiterbauelementgehäuse nach Anspruch 4, wobei ein Verhältnis der Tiefe zu der Breite der Kunstharzeinheit (410), angeordnet in der Periphernut, im Bereich von 1:1,5 ≈ 1:6 liegt.

6. Halbleiterbauelementgehäuse nach einem der Ansprüche 1 bis 5, wobei die Nut (14a, 14b, 19a, 19b) mit einer Gestalt einer geschlossenen Schleife versehen ist.

7. Halbleiterbauelementgehäuse nach einem der Ansprüche 1 bis 6, wobei die Kunstharzeinheit (410) ein erstes Durchgangsloch (411) und ein zweites Durchgangsloch (412), von dem ersten Durchgangsloch (411) beabstandet, beinhaltet, wobei das erste und das zweite Durchgangsloch (411, 412) zwischen der Periphernut und der Trennnut vorgesehen sind, und wobei ein weiterer Anteil des ersten Metallkörpers in dem ersten Durchgangsloch (411) angeordnet ist und ein weiterer Anteil des zweiten Metallkörpers in dem zweiten Durchgangsloch (412) angeordnet ist.

8. Halbleiterbauelementgehäuse nach Anspruch 7, wobei eine erste Bodenbreite des weiteren Anteils des ersten Metallkörpers größer als eine zweite Bodenbreite des weiteren Anteils des zweiten Metallkörpers ist.

9. Halbleiterbauelementgehäuse nach einem der Ansprüche 1 bis 7, wobei eine Breite der Trennnut größer als eine Breite der Periphernut ist.

10. Halbleiterbauelementgehäuse nach einem der Ansprüche 1 bis 9, wobei eine Höhe der Nut (14a, 14b, 19a, 19b) kleiner als eine Höhe zwischen einer Bodenfläche (11c) des Hohlraums (11) und der Bodenfläche (12) des Metallkörpers ist.

11. Halbleiterbauelementgehäuse nach einem der Ansprüche 1 bis 10, wobei das Isolierglied ein anderes Material als das der Kunstharzeinheit (410) aufweist.

12. Halbleiterbauelementgehäuse nach einem der Ansprüche 1 bis 11, wobei eine Höhe der Periphernut größer als eine Höhe der Trennnut ist und wobei eine äußerste Seitenfläche der Kunstharzeinheit (410) und eine äußerste Seitenfläche des Isolierglieds miteinander fluchten.

13. Halbleiterbauelementgehäuse nach einem der Ansprüche 1 bis 12, wobei ein lichtdurchlässiges Glied (50) auf dem Metallkörper angeordnet ist, wobei das lichtdurchlässige Glied (50) in einer Region angeordnet ist, die auf einer Innenseite der Periphernut vorgesehen ist.

14. Halbleiterbauelementgehäuse nach einem der Ansprüche 1 bis 12, wobei ein lichtdurchlässiges Glied (50) auf dem Metallkörper angeordnet ist, wobei das lichtdurchlässige Glied (50) mit der Nut (14a, 14b, 19a, 19b) überlappt.

15. Halbleiterbauelementgehäuse nach einem der Ansprüche 1 bis 14, wobei das lichtemittierende Bauelement eine lichtemittierende Struktur, eine erste Elektrode (152), eine zweite Elektrode (151) und ein Substrat (110) beinhaltet,
wobei die lichtemittierende Struktur eine Erste-Leitfähigkeitsart-Halbleiterschicht (120), eine Zweite-Leitfähigkeitsart-Halbleiterschicht (140) und eine aktive Schicht (130), angeordnet zwischen der Erste-Leitfähigkeitsart-Halbleiterschicht (120) und der Zweite-Leitfähigkeitsart-Halbleiterschicht (140), beinhaltet,
wobei die erste Elektrode (152) mit dem ersten Metallkörper und der Erste-Leitfähigkeitsart-Halbleiterschicht (120) elektrisch verbunden ist, und wobei die zweite Elektrode (151) mit dem zweiten Metallkörper und der Zweite-Leitfähigkeitsart-Halbleiterschicht (140) elektrisch verbunden ist, und wobei das Substrat (110) auf der lichtemittierenden Struktur angeordnet ist.

## Revendications

1. Boîtier de dispositif semi-conducteur comprenant :
une unité en résine (410) ;
un corps métallique comprenant une cavité (11) disposée sur l'unité en résine (410) ; et
un dispositif émetteur de lumière disposé dans la cavité (11),
dans lequel le corps métallique comprend un premier corps métallique et un second corps métallique, dans lequel un élément isolant est disposé entre le premier corps métallique et le second corps métallique,
dans lequel une partie du premier corps métallique, une partie du second corps métallique et une partie de l'élément isolant sont exposées à la cavité (11),
dans lequel le dispositif d'émission de lumière est connecté électriquement à la partie du premier corps métallique et à la partie du second corps métallique, et
dans lequel le corps métallique comprend en outre une rainure (14a, 14b, 19a, 19b) au niveau d'une surface inférieure (12) du corps métallique,
**caractérisé en ce que** la rainure (14a, 14b, 19a, 19b) comprend une rainure périphérique et une rainure de séparation,
dans lequel la rainure de séparation se superpose verticalement à l'élément isolant,
dans lequel la rainure périphérique est pratiquée le long de la périphérie du corps métallique,
dans lequel la rainure de séparation est reliée à la rainure périphérique à la périphérie du corps métallique, dans lequel l'unité en résine (410) est disposée dans la rainure de séparation et la rainure périphérique, et dans lequel une partie de l'unité en résine (410) disposée dans la rainure périphérique a une épaisseur d1 supérieure à l'épaisseur d2 d'une autre partie de l'unité en résine (410) disposée dans la rainure de séparation.

2. Boîtier de dispositif semi-conducteur selon la revendication 1, dans lequel la rainure de séparation sépare la rainure périphérique en une première rainure (14a) dans une surface inférieure (12a) du premier corps métallique et une seconde rainure (14b) dans une surface inférieure (12b) du second corps métallique.

3. Boîtier de dispositif semi-conducteur selon la revendication 2, dans lequel la rainure de séparation comprend une troisième rainure (19a) disposée sous le premier corps métallique, et une quatrième rainure (19b) disposée sous le second corps métallique.

4. Boîtier de dispositif semi-conducteur selon l'une quelconque des revendications 1 à 3, dans lequel une largeur de l'unité en résine (410) dans la rainure périphérique est plus grande qu'une profondeur de l'unité en résine (410) dans la rainure périphérique.

5. Boîtier de dispositif semi-conducteur selon la revendication 4, dans lequel le rapport entre la profondeur et la largeur de l'unité en résine (410) disposée dans la rainure périphérique est compris entre 1:1,5 et 1:6.

6. Boîtier de dispositif semi-conducteur selon l'une quelconque des revendications 1 à 5, dans lequel la rainure (14a, 14b, 19a, 19b) a une forme de boucle fermée.

7. Boîtier de dispositif semi-conducteur selon l'une quelconque des revendications 1 à 6, dans lequel l'unité en résine (410) comprend un premier trou traversant (411) et un second trou traversant (412) espacé du premier trou traversant (411), dans lequel les premier et second trous traversants (411, 412) sont pratiqués entre la rainure périphérique et la rainure de séparation, et dans lequel une autre partie du premier corps métallique est disposée dans le premier trou traversant (411) et qu'une autre partie du second corps métallique est disposée dans le second trou traversant (412).

8. Boîtier de dispositif semi-conducteur selon la revendication 7, dans lequel une première largeur inférieure de l'autre partie du premier corps métallique est plus grande qu'une seconde largeur inférieure de l'autre partie du second corps métallique.

9. Boîtier de dispositif semi-conducteur selon l'une quelconque des revendications 1 à 7, dans lequel la largeur de la rainure de séparation est supérieure à la largeur de la rainure périphérique.

10. Boîtier de dispositif semi-conducteur selon l'une quelconque des revendications 1 à 9, dans lequel la hauteur de la rainure (14a, 14b, 19a, 19b) est inférieure à la hauteur entre la surface inférieure (11c) de la cavité (11) et la surface inférieure (12) du corps métallique.

11. Boîtier de dispositif semi-conducteur selon l'une quelconque des revendications 1 à 10, dans lequel l'élément isolant comprend un matériau différent de celui de l'unité en résine (410).

12. Boîtier de dispositif semi-conducteur selon l'une quelconque des revendications 1 à 11, dans lequel la hauteur de la rainure périphérique est supérieure à la hauteur de la rainure de séparation, et dans lequel la surface latérale la plus éloignée de l'unité en résine (410) et la surface latérale la plus éloignée de l'élément isolant sont affleurantes l'une par rapport à l'autre.

13. Boîtier de dispositif semi-conducteur selon l'une quelconque des revendications 1 à 12, dans lequel un élément transmetteur de lumière (50) est disposé sur le corps métallique, l'élément transmetteur de lumière (50) étant disposé dans une région qui est pratiquée sur un côté intérieur de la rainure périphérique.

14. Boîtier de dispositif semi-conducteur selon l'une quelconque des revendications 1 à 12, dans lequel un élément transmetteur de lumière (50) est disposé sur le corps métallique, l'élément transmetteur de lumière (50) chevauchant la rainure (14a, 14b, 19a, 19b).

15. Boîtier de dispositif semi-conducteur selon l'une quelconque des revendications 1 à 14, dans lequel le dispositif d'émission de lumière comprend une structure émettrice de lumière, une première électrode (152), une seconde électrode (151) et un substrat (110),
dans lequel la structure émettrice de lumière comprend une couche semi-conductrice d'un premier type de conductivité (120), une couche semi-conductrice d'un second type de conductivité (140) et une couche active (130) disposée entre la couche semi-conductrice d'un premier type de conductivité (120) et la couche semi-conductrice d'un second type de conductivité (140),
dans lequel le substrat (110) est disposé sur la structure émettrice de lumière.
